# EUROPEAN PATENT SPECIFICATION

(11) **EP 0 355 133 B1**
(45) Date of publication and mention of the grant of the patent: **16.03.1994**
(21) Application number: 89900019.4
(22) Date of filing: 11.10.1988
(51) Int. Cl.: H05K 7/10

(54) **CHIP CARRIER SOCKETS HAVING IMPROVED CONTACT TERMINALS**
FASSUNGEN FÜR CHIPTRÄGER MIT VERBESSERTEN KONTAKTEN
PRISES DE SUPPORT DE PUCE A BORNES DE CONTACT AMELIOREES

(30) Priority: 03.11.1987 US 116770
(43) Date of publication of application: 28.02.1990
(73) Proprietor: THE WHITAKER CORPORATION, Wilmington, Delaware 19808 (US)
(72) Inventor: KORSUNSKY, Iosif, Harrisburg, PA 17110 (US); KOPP, Monte, Lynn, Tower City, PA 17980 (US); GRABBE, Dimitry, G., Middletown, PA 17057 (US)
(74) Representative: Warren, Keith Stanley
(86) International application number: PCT/US88/03469
(87) International publication number: WO 89/04592

(56) References cited:
- GB-A- 1 188 768
- US-A- 3 912 984
- US-A- 4 349 238

## Description

This invention relates to chip carrier sockets and the terminals contained therein. The invention is particularly concerned with obtaining adequate contact force of the terminals against modified gull wing leads notwithstanding dimensional variations in the chip carrier as a result of manufacturing tolerances.

Integrated circuits are commonly mounted in chip carriers which are bodies of insulating material having side surfaces to which conductors from the integrated circuit extend. Traditionally, terminal pads are provided on the side surfaces of the chip carrier body and contact is made with these pads to connect the integrated circuit to conductors on a substrate such as a ceramic substrate or a circuit board. Contact is usually established with the terminal pads on the chip carrier by means of a chip carrier socket which comprises a socket body having a recess which receives the chip carrier and contact terminals in surrounding relationship to the recess so that when the chip carrier is placed in the recess, the contact terminals contact the terminal pads of the chip carrier.

From US-A-4349238 there is known an electrical connector for integrated circuit packages having a plurality of parallel, spaced leads depending from at least one side thereof, said connector comprising:
a housing defining a cavity with a channel formed in each of two opposite sides of said cavity, a plurality of terminal passages in spaced relation in the bottom of each said channel;
a plurality of terminals each mounted in a respective one of said passages in parallel spaced relationship, each said terminal having a contact arm lying against one wall of said channel and a resilient spring arm normally aligned with and spaced from said contact arm;
an insert member received in each said channel, each said insert member having a plurality of cavities each receiving a respective terminal therein, each said cavity having a lead opening providing an access to said terminal;
hold down means for holding said insert members in said housing while allowing limited relative movement of the insert members within the housing; and
an actuating cover member having a pair of spaced depending sidewalls each having a cam surface on a free end thereof, said cam surfaces engaging said insert members to cause relative sliding movement of said insert members with respect to said housing whereby said movement of said insert members causes said insert members to drive said spring arms of said terminals into engagement with leads of a package received in said connector.

Notwithstanding the relatively small size of the chip carrier socket and the contact terminals in the socket, it is necessary that each terminal be capable of exerting a sufficient contact force on a terminal pad in order to establish good electrical connection between the contact terminal and the terminal pad on the chip carrier, particularly if the terminal pad is tin plated rather than gold plated. Finally chip carriers and chip carrier sockets are subject to the dimensional variations of all mass produced parts which result from manufacturing tolerances and the design and performance requirements discussed briefly above must be satisfied even in "worst case" conditions. For example, the minimum 200 gram contact force required for each contact must be met even if the particular terminal pad that a contact terminal engages is at the lower end of the tolerance range and the contact terminal similarly is at the lower end of the tolerance range for the parts.

However, for the new emerging family of modified gull wing chip carriers, a new socket is required than is found in the prior art. The contact force, etc. discussed above must remain the same in order to insure that a proper electrical connection is maintained.

It can be appreciated from the foregoing remarks that many of the types of contact terminals used in prior art connectors are not suitable for use in chip carrier sockets which is used with modified gull wing technology. The present invention is specifically directed to the achievement of an improved chip carrier socket and contact terminal which is capable of satisfying the requirements discussed above.

For the new emerging family of modified gull wing chip carriers, a new chip carrier socket is required. Particularly, for the chip carriers that have large variations of the critical dimensions, which causes the leads of the chip carrier to not be uniformly positioned. It is therefore necessary have to the terminal of the chip carrier socket be able to compensate for the variations of positions of the leads.

The present invention consists in a chip carrier socket for an integrated circuit chip carrier having spaced apart contact leads comprising a socket body having oppositely facing first and second major surfaces, and outwardly facing side surfaces, a recess in the first major surface for reception of the chip carrier, the recess having recess side surfaces, contact receiving cavities in the socket body in surrounding relationship to the recess, a terminal in each of the cavities, each terminal having a chip carrier contacting portion for contacting a respective lead on the chip carrier and having a mounting portion for contacting a conductor on a substrate when the chip carrier socket is mounted on one surface of the substrate, each mounting portion being adjacent to the second major surface of the chip carrier socket, the chip carrier socket being characterized in that:
each terminal has a leg portion with a first resilient arm and a second resilient arm extending therefrom, the leg portion being proximate the second major surface, and the arms being spaced apart and extending toward the first major surface,
the second resilient arm has a free end portion proximate the first major surface, and a lead-in surface is provided on the free end portion, the lead-in surface facing essentially toward the recess of the chip carrier socket,
the first resilient arm has a free end portion provided with a chip carrier contacting surface facing essentially toward the free end portion of the second resilient arm, and
a spacer means is provided having slots therein to cooperate with the leads of the chip carrier, whereby
upon placement of the chip carrier in the recess, the contacting surfaces of the terminals engage the contact leads and the spacer means engages the lead-in surface, causing the first and second resilient arms to deflect relatively away from each other thereby developing contact force in each terminal.

The configuration of the terminals and the spacer may be such as to insure that the leads of the chip carrier will wipingly engage the contact surfaces of the terminals as the leads are inserted therein, thereby insuring that a positive electrical connection will be made.

The first resilient arms and the second resilient arms may be mounted on the leg portions in such a way that the majority of side forces applied to the resilient arms will not be transferred to the mounting portion of the terminals. This prevents harmful stresses from being transferred to the solder joints, thereby preventing failure of the joints. The first and second resilient arms can move about the leg portions to allow the resilient arms to adjust for any dimensional variation of the chip carrier in the chip carrier socket.

An embodiment of the invention will now be described by way of example with references to the accompanying drawings, in which:
FIGURE 1 is a perspective view of a chip carrier socket of the present invention with a terminal exploded therefrom;
FIGURE 2 is a perspective view of a cover of the present invention, with a chip carrier exploded therefrom;
FIGURE 3 is a partial cross sectional view of the chip carrier socket prior to the insertion of the cover-chip carrier subassembly therein;
FIGURE 4 is a partial cross sectional view similar to that of Figure 3, showing the chip carrier socket after the cover-chip carrier subassembly has been inserted therein;
FIGURE 5 is a cross section view taken along line 5-5 of Figure 6, showing the chip carrier being maintained in a recess of the cover; and
FIGURE 6 is a partial top plan view of the chip carrier inserted into the recess of the cover.

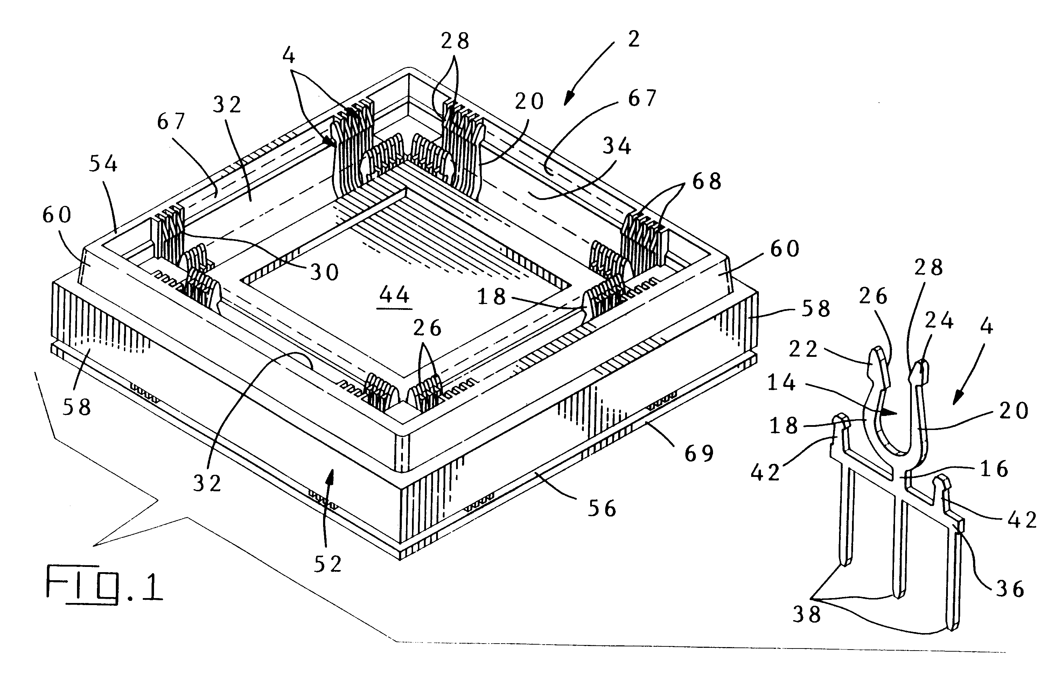

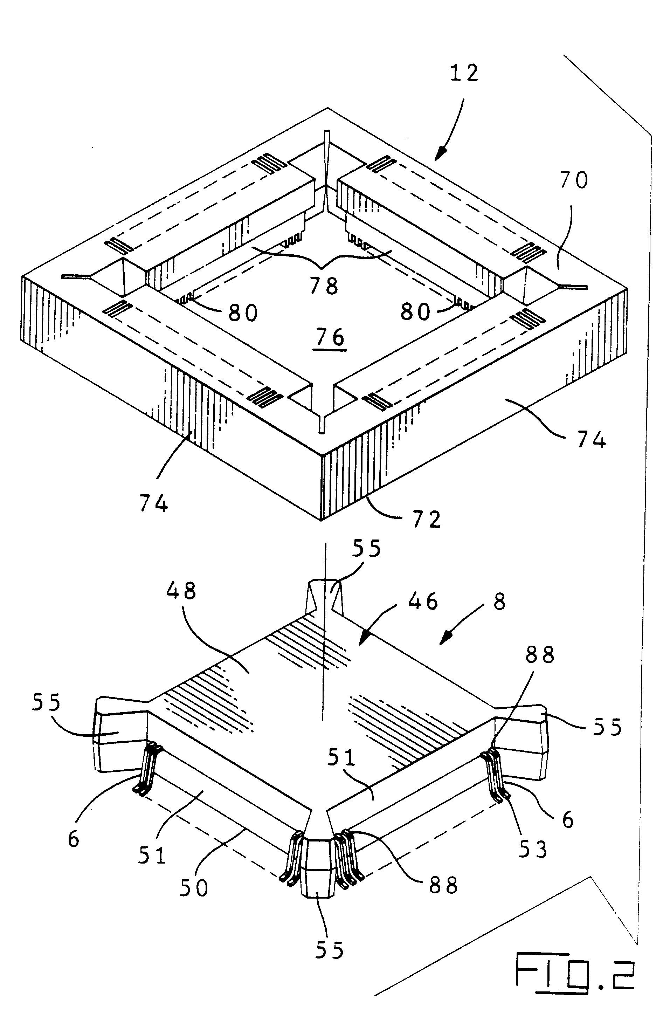

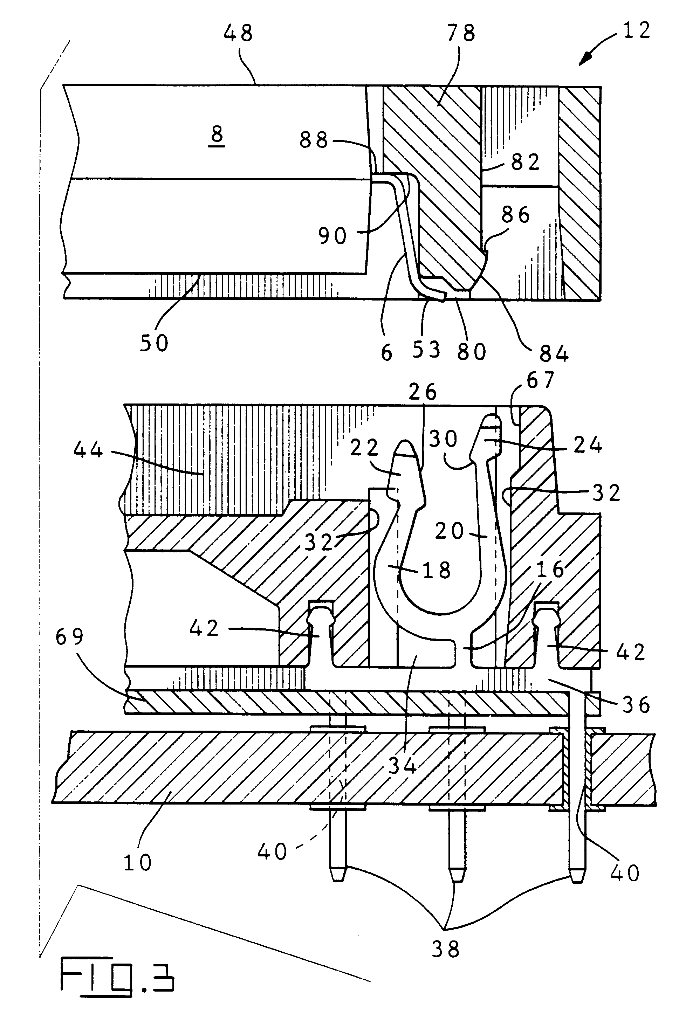

Figure 1 shows a chip carrier socket 2 containing terminals 4 which engage contact leads 6 of a chip carrier 8 (Figure 2) and which are soldered or otherwise connected to conductors on or in a substrate 10 (Figure 3). An individual terminal 4 will first be described and structural details of the chip carrier socket 2 and a cover 12 used in cooperation therewith will then be described.

Each terminal 4 is a complanate or flat member of the type commonly produced by etching or by stamping sheet metal so that it has oppositely facing major surfaces and edges extending between the major surfaces. The thickness of the terminals may vary depending upon the requirements in a particular situation.

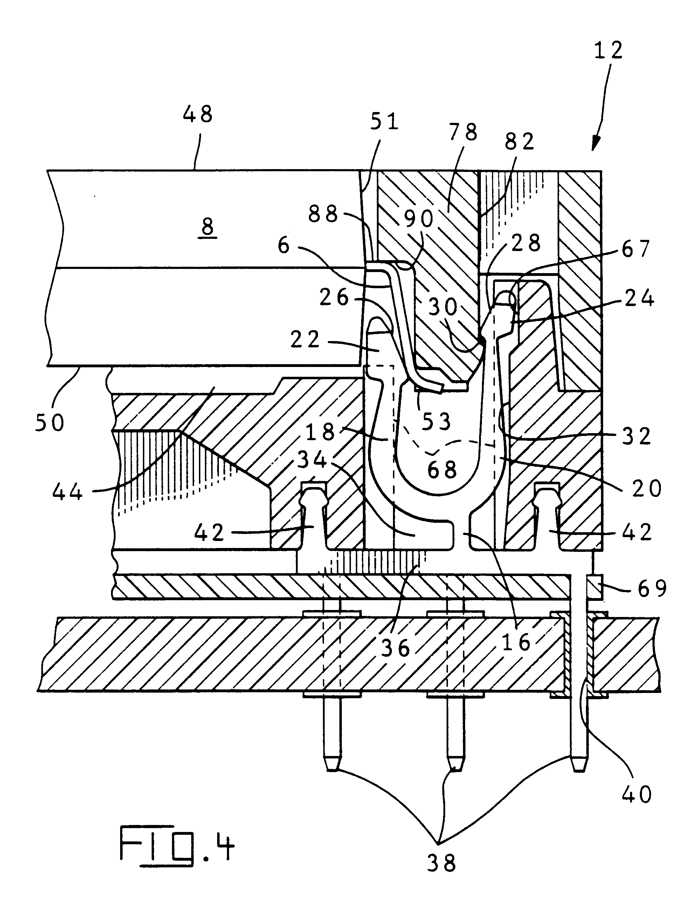

As is best shown in Figure 1, each terminal 4 comprises a resilient portion 14 having a flexible leg 16 extending from the resilient portion 14. The resilient portion 14 has a rounded, U-shaped configuration which is comprised of two resilient arms 18, 20. The first resilient arm 18 and the second resilient arm 20 have free ends 22, 24 which are spaced from each other but which are flexed relatively away from each other when the terminal 4 is stressed. As is best shown in Figures 3 and 4, resilient arm 20 is slightly longer than resilient arm 18.

The first resilient arm 18, of each terminal 4, is a contact arm and has a rightwardly facing, as viewed in Figure 3, contact surface 26 which cooperates with a respective lead 6 of the chip carrier 8. The second resilient arm 20 has a leftwardly facing lead-in surface 28 which helps to guide the cover 12 into place. Positioned below the lead-in surface 28 is a securing surface or shoulder 30 which cooperates with the cover 12 to maintain the cover 12 in position. It should be noted that neither of the free ends 22, 24 nor any portion of the resilient arms 18, 20 is in engagement with side surfaces 32 of a contact or terminal receiving cavity 34 of socket 2 when the terminal 4 is in an unstressed or first position, as shown in Figure 3.

The U-shaped resilient portion 14 is pivotally mounted on leg 16. This allows the U-shaped resilient portion 14 to adjust for any dimensional variation or misalignment of the chip carrier 8 when the chip carrier is inserted into the socket 2. Dimensional variation or misalignment of the chip carrier 8 can cause the component lead positions to vary. Therefore, it is important that the U-shaped resilient portion 14 of each terminal 4 be free to pivot in order to compensate for this varied lead position. Consequently, as the terminals 4 of the socket 2 can adjust to the varied position of the leads 6 of the chip carrier 8, a positive electrical connection will be effected and maintained between each lead 6 and the respective terminal 4.

The leg 16 of each terminal 4 is integrally attached to a horizontal bar 36 from which a number of mounting portions 38 extend downward, as is shown in Figure 1. As is indicated in Figures 3 and 4, all but one of these mounting portions 38 are removed from any given terminal 4, thereby providing the required footprint to match the holes 40 in the substrate 10.

Each horizontal bar 36 has two support portions 42 which extend upward, in the same direction as leg 16. These support portions 42 are provided to cooperate with the housing of the socket 2 to provide support for the side walls 32 of the terminal receiving cavity 34.

When the terminals 4 are contained in the chip carrier socket 2 which in turn is mounted on a substrate 10 and a chip carrier 8 is placed in a chip carrier receiving recess 44 of the chip carrier socket 2, leads 6 and a portion of cover 12 extend between free ends 22, 24 of resilient arms 18, 20, as shown in Figure 4. The effect is to impose a force on the free ends 22, 24 of the resilient arms 18, 20 of the terminals 4. As a result of the imposition of this force, the resilient arms 18, 20 function as a spring system and the arms 18, 20 are flexed relatively away from each other. The stresses induced in the terminal 4 as a result of the force are largely concentrated in the arms 18, 20, and only a very minor portion of the force is transmitted through the leg 16 to the horizontal bar 36 and to the mounting portions 38. This is a highly desirable feature because a transfer of large forces to the mounting portions 38 would create stresses on the relatively weak solder joints. These stresses would result in the failure of the connection. Consequently, it is extremely important to prevent large stresses from being transferred to the mounting portions 38.

Turning now to Figure 2, the previously identified chip carrier 8 comprises, in the disclosed embodiment, a generally square chip carrier body 46 having upper and lower major surfaces 48, 50 and side surfaces 51. Side surfaces 51 extend between first major surface 48 and second major surface 50. Side surfaces 51 are slightly bowed, as is best shown in Figures 3 and 4. The leads 6 extend into the body 46 and are connected to the integrated circuit chip (not shown) therein. These leads 6 extend from side surfaces 51 of body 46 in a generally downward fashion, (modified gull wing configuration) as is shown in the Figure 4. The end portions 53 of leads 6 are bent such that the bottom surface of end portions 53 are approaching parallel to the lower major surface 50.

Chip carrier 8 has projections 55 extending from the corners thereof. Projections 55 extend from the first major surface 48 to the second major surface 50. The sides of projections 55 have the same bowed configuration as side surfaces 51.

Referring to Figure 1, the chip carrier socket 2 comprises a socket body 52 having first and second major surfaces 54, 56 and side surfaces 58. The side surfaces 58 have an offset portion 60 proximate the first major surface 54, the offset portion 60 being provided to cooperate with the cover 12, as will be discussed. Chip carrier receiving recess 44 extends from the first major surface 54 toward the second major surface 56 and has recess side surfaces which correspond to respective side walls 32 of terminal receiving cavities 34 which extend to the second major surface 56 of socket 2. Terminal-receiving cavities 34 are provided in the recess 44 and extend from the first major surface 54 to the second major surface 56. Each cavity 34 extends from proximate a corner of the recess 44 to proximate an adjacent corner of the recess 44. Cavities 34 have a general rectangular shape. The side walls 32 which are proximate second resilient arms 20 have a recessed portion 67 which is positioned adjacent the first major surface 54. Recessed portion 67 is provided to cooperate with free end 24, thereby providing free end 24 enough space to move away from free end 22 as required. Side-by-side slots 68 are provided in side walls 32. These slots 68 cooperate with the respective terminals 4 to align the terminals 4 in the proper position. As is shown in Figure 1, the terminals 4 are positioned in the slots 68, thereby preventing the terminals 4 from engaging each other, which in turn prevents the terminals 4 from shorting. It should be noted, that in order for chip carrier 8 to be inserted into chip carrier receiving recess 44, respective inner side walls 32 can not extend all the way to the first major surface 54.

Respective terminals 4 are positioned in each slot 68 as shown in Figure 1. As is best shown in Figures 3 and 4, terminals 4 do not contact side walls 32 when the terminals 4 are in an unstressed position. However, the spacing between side walls 32 is dimensioned such that the side walls 32 act as overstress means as the terminals 4 are stressed, i.e. sidewalls 32 prevent terminals 4 from bending far enough to take a permanent set. Consequently, side walls 32 of terminal receiving cavities 34 prevent the terminals 4 from taking a permanent set which would result in an ineffective electrical connection. In order to provide the side walls 32 with enough support to prevent the overstress of the terminals 4, the support members 42 which extend from the horizontal bars 36 of the terminals 4 are positioned in the body or housing 52 of the chip carrier socket 2. The positioning of terminals 4 allows the strength of the metal terminals 4 to reinforce the strength of the plastic housing 52, thereby providing the side walls 32 with the support necessary to prevent the overstress of the terminals 4.

Mounting portions 38 of terminals 4 extend from the second major surface 56 of chip carrier socket 2. A protective strip 69 is provided proximate the ends of mounting portions 38. In the position, as shown in Figure 1, protective strip 69 cooperates with mounting portions 38 to maintain mounting portions 38 in proper position and to prevent the bending of mounting portions 38. As chip carrier socket 2 is inserted on the circuit board 10, protective strip 69 is moved along mounting portions 38 until protective strip 69 is proximate second major surface 56, thereby allowing mounting portions 38 to be inserted into circuit board 10.

Referring to Figure 2, cover 12 cooperates with the chip carrier 8, to prevent damage to the leads 6 of the chip carrier 8. Cover 12 is comprised of a first major surface 70, a second major surface 72, and side surfaces 74 extending therebetween. A chip carrier receiving recess 76 is provided in cover 12. The chip carrier receiving recess 76 extends from the first major surface 70 to the second major surface 72.

Extending in the recess 76 are chip carrier protective arms 78 which cooperate with the leads 6 of the chip carrier 8, as shown in Figures 3 and 4. Each lead 6 of chip carrier 8 is positioned in a slot 80 of arm 78. These slots 80 are provided to prevent leads 6 from electrically engaging one another, and also to provide protection to the leads 6, preventing the leads 6 from being damaged as the chip carrier 8 is inserted into the chip carrier socket 2.

As is best shown in Figures 3 and 4, protective arms 78 have surfaces 82 which cooperate with second resilient arms 20. Lead-in surfaces 84 and shoulders 86 are provided on arms 78 proximate the second major surface 72.

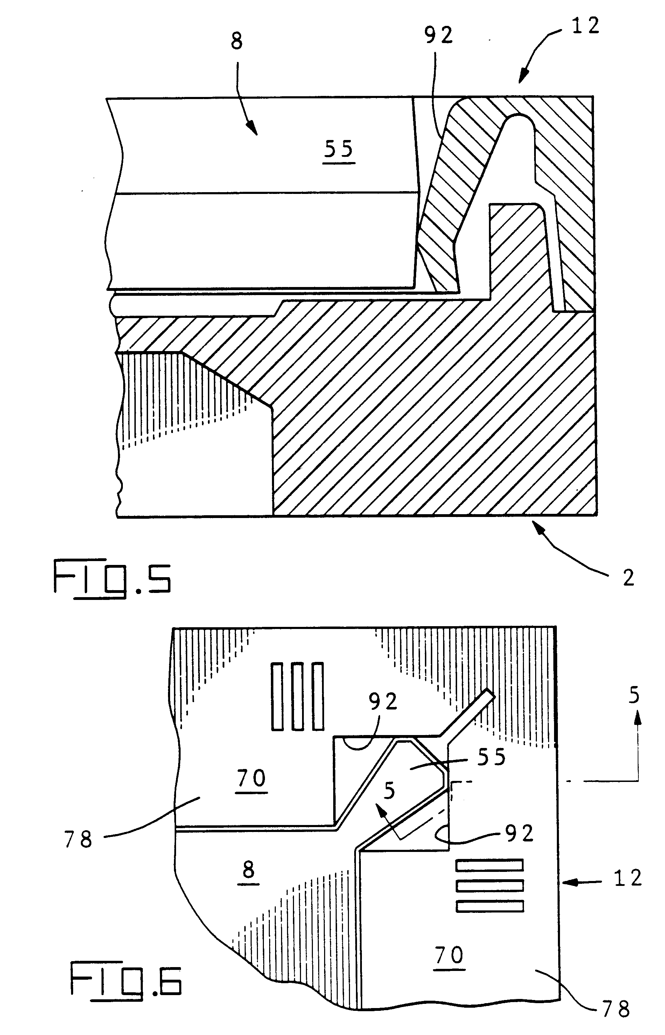

Chip carrier 8 is inserted into the cover 12 through the second major surface 72 thereof. Insertion of the chip carrier 8 continues until leading surfaces 88 of the leads 6 engage surfaces 90 of slots 80. This engagement prevents the chip carrier 8 from being further inserted in cover 12. The chip carrier 8 is maintained in the cover 12 by the cooperation of the projections 55 of the corners of the chip carrier socket 2 and securing arms 92 of the cover 12, as is best shown in Figures 5 and 6. As is shown in Figure 5, resilient securing arms 92 engage respective surfaces of projections 55 of the chip carrier 8. These respective surfaces are angled, as shown in Figure 5. Consequently, as the chip carrier 8 is inserted into the cover 12, the resilient securing arms 92 will provide enough frictional engagement to prevent the chip carrier 8 from falling out of the recess 76 of the cover 12.

In operation, the chip carrier 8 is inserted into the cover 12 and maintained therein, as was described. The chip carrier and cover subassembly is then inserted into the chip carrier socket 2. This process is shown in Figures 3 and 4. Figure 3 shows the various parts just prior to insertion. As can be seen the terminals 4 of the chip carrier socket 2 are in an unstressed position. It should be noted that the downward force needed to insert the chip carrier-cover subassembly into the chip carrier socket 2 is applied to the cover. It should be noted that as this insertion occurs, leads 6 of chip carrier 8 are forced to conform to the shape of the slots 80 of the cover 12, as shown in Figure 4. This insures that leads 6 will be in engagement with cover 12, thereby insuring that the force applied to the leads 6 by the resilient arms 18 will be absorbed by the cover 12. Consequently, the fragile leads 6 of the chip carrier 8 are not damaged as insertion occurs, due to only minimal forces being directed at the leads.

As insertion occurs, leads 6 and protective arms 78 are inserted between the resilient arms 18, 20 of the terminals 4. However, as the width of the leads 6 and protective arms 78 is greater than the distance between the free ends 22, 24 of the resilient arms 18, 20, the resilient arms 18, 20 are forced apart. This force insures that as the insertion continues, the leads 6 will frictionally engage the contact surfaces 26 of the resilient arms 18. In other words, a contact wipe action will occur as insertion takes place.

As insertion continues, lead-in surfaces 84 of protective arms 78 will move past lead-in surfaces 28 of resilient arms 20, thereby allowing resilient arms 20 to move toward their unstressed position. This insures that shoulders 30 and 86 will cooperate to maintain the cover 12 in position on socket 12.

It is important to note that although resilient arms 20 are allowed to move toward the unstressed position, the terminals 4 never reach the unstressed position when the protective arms 78 and leads 6 are inserted therein. Consequently, a force exists at all times between the leads 6 and the contact surfaces 26 of terminals 4, thereby insuring that a positive electrical connection is maintained.

It must also be noted that cover 12 is not essential to the operation of the chip carrier socket 2. In place of cover 12, a spacer means could be provided. This spacer means would cooperate with the leads 6 and the terminals 4 in the same manner as previously described. However, the spacer means would not act as a protective handler.

## Claims

1. A chip carrier socket (2) for an integrated circuit chip carrier (8) having spaced apart contact leads (6), comprising a socket body (52) having oppositely facing first and second major surfaces (54,56) and outwardly facing side surfaces (58), a recess (44) in the first major surface (54) for reception of the chip carrier (8), the recess (44) having recess side surfaces (32), contact receiving cavities (34) in the socket body (52) in surrounding relationship to the recess (44), a terminal (4) in each of the cavities (34), each terminal (4) having a chip carrier contacting portion (14) for contacting a respective lead (6) on the chip carrier (8) and having a mounting portion (38) for contacting a conductor (40) on a substrate (10) when the chip carrier socket (2) is mounted on one surface of the substrate (10), said mounting portion (38) being adjacent to the second major surface (56) of the chip carrier socket (2), the chip carrier socket (2) being characterized in that:
each terminal (4) has a leg portion (16) with a first resilient arm (18) and a second resilient arm (20) extending therefrom, the leg portion (16) being proximate the second major surface (56), and the arms (18,20) being spaced apart and extending toward the first major surface (54),
the second resilient arm (20) has a free end portion (24) proximate the first major surface (54), and a lead-in surface (28) is provided on the free end portion (24), the lead-in surface (28) facing essentially toward the recess (44) of the chip carrier socket (2),
the first resilient arm (18) has a free end portion (22) provided with a a chip carrier contacting surface (26) facing essentially toward the free end portion (24) of the second resilient arm (20), and
a spacer means (78) is provided having slots (80) therein to cooperate with the leads (6) of the chip carrier (8), whereby
upon placement of the chip carrier (8) in the recess (44), the contacting surfaces (26) of the terminals (4) engage the contact leads (6) and the spacer means (78) engages the lead-in surface (28), causing the first and second resilient arms (18,20) to deflect relatively away from each other thereby developing contact force in each terminal (4).

2. A chip carrier socket (2) as set forth in claim 1, characterized in that the spacer means (78) has a width which is greater than the distance between the free end portions (22,24) thereby forcing the resilient arms (18,20) away from each other as the spacer means (78) is inserted between the resilient arms (18,20), which in turn causes the leads (6) of the chip carrier (8) to have a wiping action across the contacting surfaces (26) of the first resilient arms (18) as insertion of the chip carrier (8) into the recess (44) occurs.

3. A chip carrier socket (2) as set forth in claim 2, characterized in that the spacer means (78) has a lead-in surface (84) which cooperates with the lead-in surface (28) of the second resilient arm (20) when the spacer means (78) is inserted between the resilient arms (18,20), thereby preventing stubbing of the spacer means (78) on the terminals (4) as the spacer means (78) is inserted therein.

4. A chip carrier socket (2) as set forth in claim 3, characterized in that the spacer means (78) has a shoulder (86) positioned proximate the lead-in surface (84), the second resilient arm (20) has a shoulder (30) proximate its lead-in surface (28), and the shoulders (86,30) engage each other when the spacer means (78) is fully inserted between the resilient arms (18,20) of the terminals (4), latching the spacer means (78) in position between the resilient arms (18,20), thereby insuring that the leads (6) of the chip carrier (8) remain in electrical engagement with the contacting surfaces (26) of the terminals (4).

5. A chip carrier socket (2) as set forth in any preceding claim, characterized in that the spacer means (78) is a portion of a cover (12), the cover (12) having resilient means (92) adapted to cooperate with corners (55) of the chip carrier (8) to maintain the chip carrier (8) in a recess (76) of the cover (12).

6. A chip carrier socket (2) as set forth in claim 1, characterized in that the recess side surfaces (32) and inner surfaces (32) of the contact receiving cavities cooperate with the second and first resilient arms (20,18), respectively, the surfaces (32) limiting the amount of deflection for each resilient arm (18,20) and thereby acting as overstress prevention means.

7. A chip carrier socket (2) as set forth in any preceding claim, characterized in that the terminals (4) have bar portions (36) which extend from the leg portions (16), and the bar portions (36) have support portions (42) and mounting portions (38) extending therefrom in opposed directions.

8. A chip carrier socket (2) as set forth in claim 7, characterized in that the support portions (42) extend into recesses provided in the second major surface (56) of the chip carrier socket (2), the support portions (42) providing support to the socket body (52).

9. A chip carrier socket (2) as set forth in any preceding claim, 1, characterized in that the first resilient arms (18) and the second resilient arms (20) are mounted to the leg portions (16) such that the forces applied to the resilient arms (18,20) are not transferred to the mounting portions (38) of the terminals (4), the resilient arms (18,20) being allowed to move in the cavities (34) thereby allowing the resilient arms (18,20) to adjust for any dimensional variation of the chip carrier (8).

10. A chip carrier socket (2) as set forth in any preceding claim, 1, characterized in that a protective strip (69) is provided to cooperate with the mounting portions (38) of the terminals (4), and the protective strip (69) is positioned away from the second major surface (56) of the chip carrier socket (2) when the socket (2) is not inserted into a substrate (10), the protective strip (69) cooperating with the mounting portions (38) of the terminals (4) to insure that the proper spacing is maintained between the mounting portions (38) and to protect the mounting portions (38) from being bent.

11. A chip carrier socket (2) as set forth in claim 10, characterized in that the protective strip (69) is moved proximate the second major surface (56) of the socket (2) as the socket (2) is inserted into the substrate (10), thereby allowing the mounting portions (38) of the terminals (4) to cooperate with conductors of the substrate (10) to provide the electrical engagement necessary.

## Patentansprüche

1. Chipträger-Fassung (2) für einen Chipträger (8) für eine integrierte Schaltung, mit voneinander beabstandeten Kontaktleitern (6), mit einem Fassungshauptteil (52), der entgegengesetzt weisende erste und zweite größere Oberflächen (54, 56) und nach außen weisende Seitenflächen (58) hat, mit einer Ausnehmung (44) in der ersten größeren Oberfläche (54) zur Aufnahme des Chipträgers (8), wobei die Ausnehmung (44) Ausnehmungsseitenflächen (32) hat, mit Kontaktaufnahmehohlräumen (34) in dem Fassungshauptteil (52), die die Ausnehmung (44) umgeben, mit einem Anschluß (4) in jedem der Hohlräume (34), wobei jeder Anschluß (4) einen Chipträger-Kontaktabschnitt (14) zum Kontaktieren eines entsprechenden Leiters (6) an dem Chipträger (8) hat und einen Montageteil (38) zum Kontaktieren eines Leiters (40) an einem Substrat (10) hat, wenn die Chipträger-Fassung (2) an einer Oberfläche des Substrats (10) montiert ist, wobei der Montageteil (38) benachbart zu der zweiten größeren Oberfläche (56) der Chipträger-Fassung (2) ist, wobei die Chipträger-Fassung (2) **dadurch gekennzeichnet** ist, daß
- jeder Anschluß (4) einen Fußteil (16) mit einem ersten nachgiebigen Arm (18) und einem zweiten nachgiebigen Arm (20) hat, die sich davon erstrecken, wobei der Fußteil (16) benachbart zu der zweiten größeren Oberfläche (56) ist und die Arme (18, 20) voneinander beabstandet sind und sich auf die erste größere Oberfläche (54) zu erstrecken,
- der zweite nachgiebige Arm (20) einen freien Endabschnitt (24) benachbart zu der ersten größeren Oberfläche (54) hat und eine Einführfläche (28) an dem freien Endabschnitt (24) vorgesehen ist, wobei die Einführfläche (28) im wesentlichen auf die Ausnehmung (44) der Chipträger-Fassung (2) zu weist,
- der erste nachgiebige Arm (18) einen freien Endabschnitt (22) hat, der mit einer Chipträger-Kontaktfläche (26) versehen ist, die im wesentlichen auf den freien Endabschnitt (24) des zweiten nachgiebigen Arms (20) zu weist, und
- ein Abstandsglied (78) vorgesehen ist, das in sich Schlitze (80) zum Zusammenwirken mit den Leitern (6) des Chipträgers (8) hat, wodurch
- nach dem Einsetzen des Chipträgers (8) in die Ausnehmung (44) die Kontaktflächen (26) der Anschlüsse (4) an den Kontaktleitern (6) angreifen und das Abstandsglied (78) an der Einführfläche (28) angreift, wodurch die ersten und zweiten nachgiebigen Arme (18, 20) veranlaßt werden, sich relativ zueinander voneinander weg zu verformen und dadurch eine Kontaktkraft in jedem Anschluß (4) zu entwickeln.

2. Chipträger-Fassung (2) nach Anspruch 1, **dadurch gekennzeichnet,** daß das Abstandsglied (78) eine Breite hat, die größer ist als der Abstand zwischen den freien Endabschnitten (22, 24), wodurch die nachgiebigen Arme (18, 20) voneinander weg gedrückt werden, wenn das Abstandsglied (78) zwischen die nachgiebigen Arme (18, 20) eingesetzt wird, was wiederum die Leiter (6) des Chipträgers (8) veranlaßt, eine Wischwirkung über die Kontaktflächen (26) der ersten nachgiebigen Arme (18) auszu-üben, wenn das Einsetzen des Chipträgers (8) in die Ausnehmung (44) erfolgt.

3. Chipträger-Fassung (2) nach Anspruch 2, **dadurch gekennzeichnet,** daß das Abstandsglied (78) eine Einführfläche (84) hat, die mit der Einführfläche (28) des zweiten nachgiebigen Arms (20) zusammenwirkt, wenn das Abstandsglied (78) zwischen die nachgiebigen Arme (18, 20) eingesetzt wird, wodurch ein Aufstoßen des Abstandsglieds (78) an den Anschlüssen (4) verhindert ist, wenn das Abstandsglied (78) darin eingesetzt wird.

4. Chipträger-Fassung (2) nach Anspruch 3, **dadurch gekennzeichnet,** daß das Abstandsglied (78) eine Schulter (86) hat, die benachbart zu der Einführfläche (84) angeordnet ist, daß der zweite nachgiebige Arm (20) eine Schulter (30) benachbart zu seiner Einführfläche (28) hat und daß die Schultern (86, 30) aneinander angreifen, wenn das Abstandsglied (78) vollständig zwischen die nachgiebigen Arme (18, 20) der Anschlüsse (4) eingesetzt ist, wobei das Abstandsglied (78) in seiner Stellung zwischen den nachgiebigen Armen (18, 20) verriegelt wird, wodurch sichergestellt wird, daß die Leiter (6) des Chipträgers (8) in elektrischem Eingriff mit den Kontaktflächen (26) der Anschlüsse (4) bleiben.

5. Chipträger-Fassung (2) nach einem der vorhergehenden Ansprüche, dadurch **gekennzeichnet,** daß das Abstandsglied (78) ein Teil einer Abdeckung (12) ist, wobei die Abdeckung (12) nachgiebige Mittel (92) hat, die zum Zusammenwirken mit Ecken (55) des Chipträgers (8) ausgebildet sind, um den Chipträger (8) in einer Ausnehmung (76) der Abdeckung (12) zu halten.

6. Chipträger-Fassung (2) nach Anspruch 1, **dadurch gekennzeichnet,** daß die Seitenflächen (32) der Ausnehmung und innere Oberflächen (32) der Kontaktaufnahmehohlräume mit den zweiten und ersten nachgiebigen Armen (20, 18) zusammenwirken, wobei die Flächen (32) den Betrag der Verformung für jeden nachgiebigen Arm (18, 20) begrenzen und dadurch als Mittel zur Verhinderung einer Überbeanspruchung dienen.

7. Chipträger-Fassung (2) nach einem der vorhergehenden Ansprüche, dadurch **gekennzeichnet,** daß die Anschlüsse (4) Stangenteile (36) haben, die sich von den Fußteilen (16) erstrecken, und daß die Stangenteile (36) Stützabschnitte (42) und Montageabschnitte (38) haben, die sich davon in entgegengesetzten Richtungen erstrecken.

8. Chipträger-Fassung (2) nach Anspruch 7, **dadurch gekennzeichnet,** daß die Stützabschnitte (42) sich in Ausnehmungen erstrecken, die in der zweiten größeren Oberfläche (56) der Chipträger-Fassung (2) vorgesehen sind, wobei die Stützabschnitte (42) eine Abstützung für den Fassungshauptteil (52) bieten.

9. Chipträger-Fassung (2) nach einem der vorhergehenden Ansprüche, dadurch **gekennzeichnet,** daß die ersten nachgiebigen Arme (18) und die zweiten nachgiebigen Arme (20) an den Fußteilen (16) so angeordnet sind, daß die auf die nachgiebigen Arme (18, 20) ausgeübten Kräfte nicht auf die Montageabschnitte (38) der Anschlüsse (4) übertragen werden, wobei es den nachgiebigen Armen (18, 20) gestattet ist, sich in den Hohlräumen (34) zu bewegen, wodurch es den nachgiebigen Armen (18, 20) ermöglicht ist, eine Einstellung für irgendwelche Dimensionsabweichungen des Chipträgers (8) zu bewirken.

10. Chipträger-Fassung (2) nach einem der vorhergehenden Ansprüche, dadurch **gekennzeichnet,** daß ein Schutzstreifen (69) zum Zusammenwirken mit den Montageabschnitten (38) der Anschlüsse (4) vorgesehen ist, und daß der Schutzstreifen (69) weg von der zweiten größeren Oberfläche (56) der Chipträger-Fassung (2) angeordnet ist, wenn die Fassung (2) nicht in ein Substrat (10) eingesetzt ist, wobei der Schutzstreifen (69) mit den Montageabschnitten (38) der Anschlüsse (4) zusammenwirkt, um sicherzustellen, daß der richtige Abstand zwischen den Montageabschnitten (38) aufrechterhalten wird, und um die Montageabschnitte (38) gegen ein Biegen zu schützen.

11. Chipträger-Fassung (2) nach Anspruch 10, **dadurch gekennzeichnet,** daß der Schutzstreifen (69) benachbart zu der zweiten größeren Oberfläche (56) der Fassung (2) bewegt wird, wenn die Fassung (2) in das Substrat (10) eingesetzt wird, wodurch es den Montageabschnitten (38) der Anschlüsse (4) gestattet ist, mit Leitern des Substrats (10) zusammenzuwirken, um den notwendigen elektrischen Eingriff zu schaffen.

## Revendications

1. Socle (2) de support intermédiaire pour puce pour un support intermédiaire (8) de puce à circuits intégrés ayant des sorties de contact espacées (6), comportant un corps (52) de logement présentant des première et seconde surfaces principales opposées (54, 56) et des surfaces latérales (58) tournées vers l'extérieur, un évidement (44) dans la première surface principale (54) pour recevoir le support intermédiaire (8) de puces, l'évidement (44) ayant des surfaces latérales (32) d'évidement, des cavités (34) de réception de contact dans le corps (52) du socle dans une disposition entourant l'évidement (44), une borne (4) dans chacune des cavités (34), chaque borne (4) ayant une partie (14) en contact avec le support intermédiaire de puce pour établir un contact avec une sortie respective sur le support intermédiaire (8) de puce et ayant une partie de montage (38) pour établir un contact avec un conducteur (40) sur un substrat (10) lorsque le socle (2) de support intermédiaire de puce est monté sur une surface du substrat (10), ladite partie de montage (38) étant adjacente à la seconde surface principale (56) du socle (2) de support intermédiaire de puce, le socle (2) de support intermédiaire de puce étant caractérisé en ce que :
chaque borne (4) comporte une partie de branche (16) de laquelle s'étendent un premier bras élastique (18) et un second bras élastique (20), la partie de branche (16) étant proche de la seconde surface principale (56), et les bras (18, 20) étant espacés et s'étendant vers la première surface principale (54),
le second bras élastique (20) ayant une partie extrême libre (24) proche de la première surface principale (54), et une surface d'entrée (28) est prévue sur la partie extrême libre (24), la surface d'entrée (28) étant tournée essentiellement vers l'évidement (44) du socle (2) de support intermédiaire de puce,
le premier bras élastique (18) comporte une partie extrême libre (22) pourvue d'une surface (26) d'entrée en contact avec le support intermédiaire de puce, tournée essentiellement vers la partie extrême libre (24) du second bras élastique (20), et
des moyens d'écartement (78) sont prévus, présentant des rainures (80) destinées à coopérer avec les sorties (6) du support intermédiaire (8) de puce, grâce à quoi
lors de la mise en place du support intermédiaire (8) de puce dans l'évidement (44), les surfaces (26) de contact des bornes (4) portent contre les sorties de contact (6) et les moyens d'écartement (78) portent contre la surface d'entrée (28), amenant les premier et second bras élastiques (18, 20) à s'éloigner l'un de l'autre en fléchissant, en développant ainsi une force de contact dans chaque borne (4).

2. Socle (2) pour support intermédiaire de puce selon la revendication 1, caractérisé en ce que les moyens d'écartement (78) ont une largeur qui est plus grande que la distance entre les parties extrêmes libres (22, 24), obligeant ainsi les bras élastiques (18, 20) à s'écarter l'un de l'autre pendant que les moyens d'écartement (78) sont insérés entre les bras élastiques (18, 20), ce qui, par suite, amène les sorties (6) du support intermédiaire (8) de puce à produire une action de frottement sur les surfaces (26) de contact des premiers bras élastiques (18) pendant l'insertion du support intermédiaire (8) de puce dans l'évidement (44).

3. Socle (2) pour support intermédiaire de puce selon la revendication 2, caractérisé en ce que les moyens d'écartement (78) ont une surface d'entrée (84) qui coopère avec la surface d'entrée (28) du second bras élastique (20) lorsque les moyens d'écartement (78) sont insérés entre les bras élastiques (18, 20), empêchant ainsi les moyens d'écartement (78) de buter sur les bornes (4) pendant que les moyens d'écartement (78) y sont insérés.

4. Socle (2) pour support intermédiaire de puce selon la revendication 3, caractérisé en ce que les moyens d'écartement (78) ont un épaulement (86) placé à proximité de la surface d'entrée (84), le second bras élastique (20) comporte un épaulement (30) proche de sa surface d'entrée (28), et les épaulements (86, 30) portent l'un contre l'autre lorsque les moyens d'écartement (78) sont totalement insérés entre les bras élastiques (18, 20) des bornes (4), verrouillant les moyens d'écartement (78) en position entre les bras élastiques (18, 20), assurant ainsi que les sorties (6) du support intermédiaire (8) puce restent en engagement électrique avec les surfaces de contact (26) des bornes (4).

5. Socle (2) pour support intermédiaire de puce selon l'une quelconque des revendications précédentes, caractérisé en ce que les moyens d'écartement (78) forment une partie d'un couvercle (12), le couvercle (12) ayant des moyens élastiques (92) conçus pour coopérer avec des angles (55) du support intermédiaire (8) de puce afin de maintenir le support intermédiaire (8) de puce dans un évidement (76) du couvercle (12).

6. Socle (2) pour support intermédiaire de puce selon la revendication 1, caractérisé en ce que les surfaces latérales (32) de l'évidement et les surfaces intérieures (32) des cavités de réception de contact coopèrent avec les second et premier bras élastiques (20, 18), respectivement, les surfaces (32) limitant l'importance de la flexion de chaque bras élastique (18, 20) et agissant ainsi en tant que moyen empêchant les contraintes excessives.

7. Socle (2) pour support intermédiaire de puce selon l'une quelconque des revendications précédentes, caractérisé en ce que les bornes (4) ont des parties (36) à barre qui s'étendent depuis les parties à branches (16), et les parties à barre (36) ont des parties de support (42) et les parties de montage (38) qui en partent dans des directions opposées.

8. Socle (2) pour support intermédiaire de puce selon la revendication 7, caractérisé en ce que les parties (42) de support pénètrent dans des évidements prévus dans la seconde surface principale (56) du socle (2) pour support intermédiaire de puce, les parties de support (42) fournissant un support pour le corps (52) du socle.

9. Socle (2) pour support intermédiaire de puce selon l'une quelconque des revendications précédentes, caractérisé en ce que les premiers bras élastiques (18) et les seconds bras élastiques (20) sont montés sur les parties à branche (16) de manière que les forces appliquées aux bras élastiques (18, 20) ne soient pas transmises aux parties de montage (38) des bornes (4), les bras élastiques (18, 20) pouvant se déplacer dans les cavités (34), permettant ainsi aux bras élastiques (18, 20) de s'ajuster en fonction de toute variation de dimension du support intermédiaire (8) de puce.

10. Socle (2) pour support intermédiaire de puce selon l'une quelconque des revendications précédentes, caractérisé en ce qu'une bande protectrice (69) est prévue pour coopérer avec les parties (38) de montage des bornes (4), et la bande protectrice (69) est positionnée à l'écart de la seconde surface principale (56) du socle (2) pour support intermédiaire de puce lorsque le socle (2) n'est pas inséré dans un substrat (10), la bande (69) de support coopérant avec les parties (38) de montage des bornes (4) pour assurer que l'écartement approprié est maintenu entre les parties (38) de montage et pour protéger les parties (38) de montage contre le pliage.

11. Socle (2) pour support intermédiaire de puce selon la revendication 10, caractérisé en ce que la bande protectrice (69) est amenée à proximité de la seconde surface principale (56) du socle (2) pendant que le socle (2) est inséré dans le substrat (10), permettant ainsi aux parties de montage (38) des bornes (4) de coopérer avec des conducteurs du substrat (10) pour établir l'engagement électrique nécessaire.
